# EUROPEAN PATENT APPLICATION

(11) **EP 0 777 252 A1**
(43) Date of publication of application: **04.06.1997**
(21) Application number: 96308619.4
(22) Date of filing: 28.11.1996
(51) Int. Cl.: H01J 9/02, C23C 14/30

(54) **Electron beam evaporation apparatus and method**

(30) Priority: 30.11.1995 US 565040
(71) Applicant: THE BOC GROUP, INC., Murray Hill, New Providence, New Jersey 07974-2082 (US)
(72) Inventor: Hill, Russell J., El Cerrito, California 94530 (US); Kaemmer, Brian J., Napa, California 94558 (US)
(74) Representative: Bousfield, Roger James

(57) **Abstract**

An apparatus for depositing a Spindt emitter forming substance on a field emission source substrate by electron beam evaporation so that a maximum allowed deposition angle is not exceeded, comprises:
at least one electron beam evaporation source located (10,12) opposite to the substrate (2) and generating at least one vapour cloud (18,20) to deposit the substance on at least two regions of the substrate located adjacent to one another; and
at least one partition (26) configured to confine at least one vapour cloud emanating from the at least one electron beam evaporation source to each of the at least two regions so that deposition on each one of the at least two regions does not exceed the maximum allowed deposition angle (a) in other of the at least two regions;
the at least one electron beam evaporation source spaced from the substrate a source to substrate distance so that the maximum allowed deposition angle is not exceeded in each of the at least two regions of the substrate;
the source to substrate distance being less than that required to not exceed the maximum allowed deposition angle had a single electron beam evaporation source been used simultaneously to deposit the substance on the at least two regions of the substrate.

## Description

The invention relates to an apparatus and method for depositing a Spindt emitter forming substance on a field emission source substrate so that a maximum allowed deposition angle is not exceeded. More particularly, the invention relates to such an apparatus and method in which multiple electron beam evaporation sources are utilised for effecting the deposition. Even more particularly, the invention relates to such an apparatus and method in which partitions are used to isolate vapour clouds of the electron beam evaporation sources.

The formation of Spindt emitters on field emission source substrates, such as those used for displays, requires deposition to be conducted without exceeding a maximum allowed deposition angle. In the formation of field emission displays, a conductor layer formed of amorphous silicon is deposited on a substrate. Following this, an insulator layer, such as silicon dioxide, is deposited on the conductor layer. These layers are deposited by thin film techniques, such as chemical vapour deposition. Thereafter, through the use of etching techniques, vias or small holes are formed in the conductor and insulator layers. Low angle deposition is the conducted to deposit a lift-off layer of aluminium or nickel on the insulator layer without closing off the vias. The Spindt emitters are then formed within the vias by orthogonally depositing molybdenum or other suitable metal into the vias and onto the aluminium or nickel lift-off layer. An acid bath is then utilised to remove the lift-off layer and excess molybdenum or other suitable metal forming a layer on top of the lift-off layer to leave conically-shaped cathodes within the vias known as Spindt emitters.

An angle representing the deposition angle is the angle formed between two adjacent imaginary lines extending from the electron beam evaporation source to the substrate. One line represents the source to substrate distance and the other line extends from the edge of the substrate back to the electron beam evaporation source. If the maximum allowed deposition angle is exceeded, some of the Spindt emitters will be mal-formed and therefore, not functional.. Such mal-formation may be exhibited by defective Spindt emitters that are inclined from the normal to a sufficient extent that they are shorted out against the vias.

If sectionally viewed, the two imaginary lines, discussed above, and the substrate will form a right triangle with the line representing the source to substrate distance forming a ninety degree angle with the substrate. Seen from this vantage, it is apparent that in order to prevent massive defects in the finished display, the electron beam evaporation source must be spaced a sufficient distance away from the field emission display substrate to prevent the maximum allowed deposition angle from being exceeded. Moreover, the larger the substrate, the greater the source to substrate distance to preserve the maximum allowed deposition angle. Thus, in forming field emission displays, the source to substrate distance is greater than that normally encountered in electron beam depositions. Such distance translates into in larger than normal vacuum chambers and increased equipment costs. As an example of the foregoing, field emission displays are made on glass substrates larger than 35 cm. x 45 cm. Coating large substrates such as these using a single electron beam evaporation source and small angle design rules would need very long (up to 3.66 meters) source to substrate distances.

The invention is concerned with the provision of an electron beam evaporation apparatus and method in which the source to substrate distance is less than that required in prior art depositions when a rigorous maximum deposition angle is to be controlled.

The present invention provides an apparatus for depositing a Spindt emitter forming substance on a field emission source substrate by electron beam evaporation so that a maximum allowed deposition angle is not exceeded. The apparatus comprises at least one electron beam evaporation source located opposite to the substrate to deposit the substance on at least two regions of the substrate located adjacent to one another. At least one partition is configured to isolate at least one vapour cloud emanating from the at least one electron beam evaporation source so that deposition on each one of the at least two regions does not exceed the maximum allowed deposition angle in other of the at least two regions. The at least one electron beam evaporation source is spaced from the substrate a source to substrate distance so that the maximum allowed deposition angle is not exceed in each of the at least two regions of the substrate. The source to substrate distance is less than that required to not exceed the maximum allowed deposition angle had a single electron beam evaporation source been used to simultaneously deposit the substance on the at least two regions of the substrate.

In another aspect, the invention provides a combination comprising a substrate and an apparatus. The substrate is the type used for a field emission source and has vias penetrating lift-off and insulator layers. The apparatus forms Spindt emitters within the vias through electron beam evaporation and such that the maximum allowed deposition angle is not exceeded. The apparatus comprises at least one electron beam evaporation source located opposite to the substrate and generating at least one vapour cloud to deposit a substance forming the Spindt emitters on at least two regions of the substrate located adjacent to one another. At least one partition is configured to confine the at least one vapour cloud to each of the at least two regions so that deposition on each one of the at least two regions does not exceed the maximum allowed deposition angle in another of the at least two regions. The at least one electron beam evaporation source is spaced from the substrate, a source to substrate distance, so that the maximum allowed deposition angle is not exceeded in each of the at least two regions of the substrate. The source to substrate distance is less than that required to not exceed the maximum allowed deposition angle had a single electron beam evaporation source been used simultaneously to deposit the substance on the at least the two regions of the substrate.

In still another aspect, the invention provides a method for depositing a Spindt emitter forming substance on a substrate by electron beam evaporation so that a maximum allowed deposition angle is not exceeded. The method comprises depositing the substance on at least two adjacent regions of the substrate by electron beam evaporation of the substance in at least one electron beam evaporation source. The at least one electron beam evaporation source is spaced from the substrate a source to substrate distance so that the maximum allowed deposition angle is not exceed in each of the at least two adjacent regions of the substrate. The source to substrate distance is less than that required to not exceed the maximum allowed deposition angle had a single electron beam evaporation source been used simultaneously to deposit the substance in all of the at least two adjacent regions of the substrate. At least one partition is positioned to confine at least one vapour cloud emanating from the at least one electron beam evaporation source to each of the at least two adjacent regions so that deposition on each one of the at least two regions does not exceed the maximum allowed deposition angle in other of the at least two regions.

In the simplest case, a single electron beam evaporation source is used to deposit Spindt emitters on two regions of the substrate. In such case, the substrate is rotated. It is to be noted that partitions may be fixed with respect to multiple electron beam sources or conversely, may be rotated with the substrates. In order to reduce deposition times, multiple deposition sources can be used with each source corresponding to a region and there being provided a number of partitions equal to the number of sources employed. Although, generally speaking, each region will comprise a portion of the substrate to be finished into a single or multiple displays, the term "region" is more broadly used herein and in the claims to include any sub-area of the substrate and such sub-area could include portions of the substrate to be finished into more than one display or more than one field emission display source.

In all aspects of the present invention, the use of one or more electron beam evaporation sources to deposit a substance region by region allows for a reduction in the source to substrate distance because the electron beam evaporation source(s) is being used to effect a deposit on a smaller region or area than the area of the entire substrate. Since deposition in one region by an electron beam evaporation source will almost automatically exceed the maximum allowed deposition angle in an adjacent region, a partition is used to confine the vapour cloud.

For a better understanding of the invention reference will now be made, by way of exemplification only, to the accompanying drawings in which:
Figure 1 is a sectional, schematic illustration view of an apparatus in accordance with the invention;
Figure 2 is the view taken along line 2-2 of Figure 1; and
Figure 3 is a schematic plane view of a substrate used in the invention.

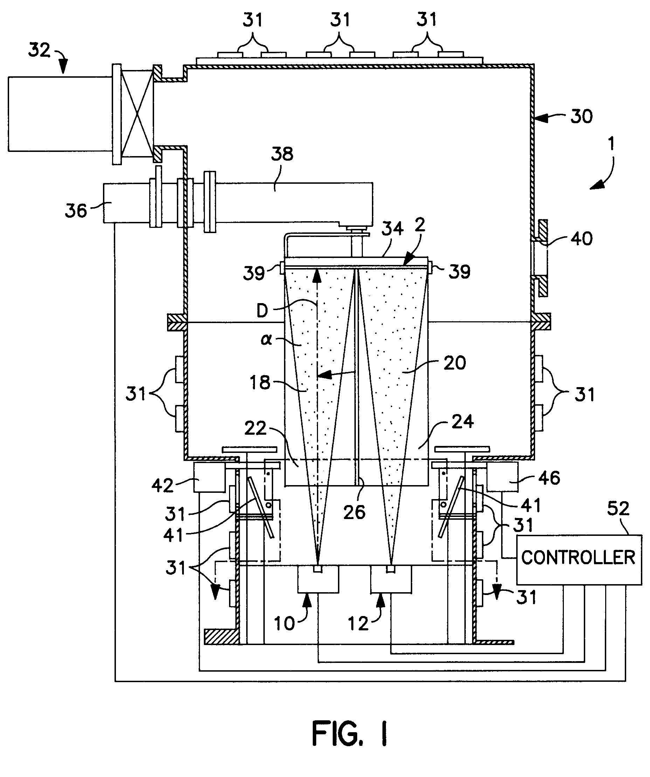

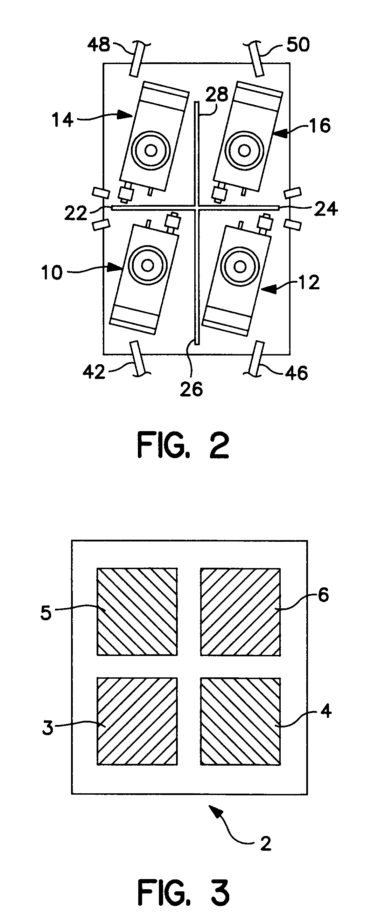

With reference to Figures 1 and 2, there is shown an apparatus 1 designed to deposit a substance such a molybdenum or other suitable metal on a flat screen display substrate 2.

With reference to Figure 3, a flat screen display substrate 2 has four adjacent regions, 3, 4, 5 and 6, each of which when finished will form a complete display. Although the display substrate 2 has four regularly shaped regions, each to be finished into a single, square-shaped display, the invention is not so limited. In practice, there could be several irregularly shaped displays in any region and in fact, a display could straddle two adjacent regions.

A set of four electron beam evaporation sources, 10, 12, 14 and 16 is located opposite to the substrate 2 to perform the required deposition. Evaporation of the deposition substance produces vapour clouds emanating from each of the electron beam evaporation sources 10, 12, 14, and 16. The vapour clouds act as a transport mechanism to deposit the deposition substance on the substrate. Vapour clouds 18 and 20 that have emanated from the electron beam evaporation sources 10 and 12 are illustrated. The vapour clouds emanating from the electron beam evaporation sources 14 and 16, although not illustrated, would have the same appearance.

In order to isolate or confine the deposition of the vapour clouds to a particular region, a set of four partitions 22, 24, 26 and 28 is provided. If the partitions 22-28 were not provided, then deposition by electron beam evaporation source 10, while not exceeding the maximum allowed deposition angle in region 3, might exceed such angle in region 4.

The distance of the substrate 2 from the electron beam evaporation sources 12-16 is designated by a distance "D". Distance D is the source to substrate distance. The maximum allowed deposition angle is indicated by "a". Such angle is typically set at about five degrees for field emission display formation. In order simultaneously to form Spindt emitters on regions 3-6 of the substrate 2, with a single electron beam evaporation source, the source to substrate distance D would have to be much larger than that illustrated for apparatus 1 because the deposition area would be larger. Thus, the invention allows the source to substrate distance to be reduced over deposition equipment that would employ a single deposition source simultaneously to form a deposit over the entire substrate area.

Electron beam evaporation sources 12-16, the substrate 2 and the partitions 24 through 28 are mounted within a vacuum chamber 30 having cooling channels 31. A cryopump or turbomolecular pump 32 is attached to a vacuum chamber 30 in order to pump the chamber 30 down to vacuum conditions necessary to effect the deposition. The substrate 2 is mounted on a substrate holder 34 that is in turn rotated by a rotation motor 36 acting through a vacuum feed-through 38. Additionally, the partitions 22-28 are connected to the substrate holder 34 by tabs 39 so that they rotate with the substrate 2 when mounted on the substrate holder 34. As will be appreciated by those skilled in the art, the partitions 22-28 could be stationary and simply connected to vacuum chamber 30. There will be a slight gap between the top of the partitions 22-28 and the substrate 2. This gap may be designed to allow zero or some small overlay of coating depending on the specific design rules in force for the product in question. In this regard, in the event that the substrate is designed with a field emission source straddling two regions, the partitions 22-28 are spaced from such substrate so that the maximum allowed deposition angle of the design rule is preserved. The substrate 2 is introduced and removed from the vacuum chamber 30 through a substrate transfer port 40.

Although the electron beam evaporation sources 12-16 are illustrated as being fixed in position within the vacuum chamber 30, a lower transfer port could be provided to introduce the electron beam evaporation sources 12-16 into the vacuum chamber 30 and on to a mechanism, known in the art, for lifting the electron beam evaporation sources 12 to 16 into the appropriate position. In this regard, a conventional source shutter 41 is provided for covering the electron beam evaporation sources 12-16.

Rate monitors 42, 46, 48 and 50 are provided from monitoring the continued operation of the electron beam evaporation sources 12, 14, 16 and 18. If one or more of the electron beam evaporation sources 10, 12, 14 and 16 fails, monitors 42-50 will sense such failure. A controller 52 will then calculate the remaining amount of deposit required and will adjust the deposit time accordingly by increasing the remaining deposit time by four-thirds.

Although the present invention has been shown with four electron beam evaporation sources 10, 12, 14 and 16, there could be more or fewer sources utilised in accordance with the deposition demands of a particular substrate. In this regard, if a substrate had only two adjacent areas, a single partition would be used to a vapour cloud emanating from one electron beam evaporation source. If a substrate had six adjacent areas six electron beam evaporation sources and six partitions might be utilised.

## Claims

1. An apparatus for depositing a Spindt emitter forming substance on a field emission source substrate by electron beam evaporation so that a maximum allowed deposition angle is not exceeded, the apparatus comprising:
at least one electron beam evaporation source located opposite to the substrate and generating at least one vapour cloud to deposit the substance on at least two regions of the substrate located adjacent to one another; and
at least one partition configured to confine at least one vapour cloud emanating from the at least one electron beam evaporation source to each of the at least two regions so that deposition on each one of the at least two regions does not exceed the maximum allowed deposition angle in other of the at least two regions;
the at least one electron beam evaporation source spaced from the substrate a source to substrate distance so that the maximum allowed deposition angle is not exceeded in each of the at least two regions of the substrate;
the source to substrate distance being less than that required to not exceed the maximum allowed deposition angle had a single electron beam evaporation source been used simultaneously to deposit the substance on the at least two regions of the substrate.

2. Apparatus according to Claim 1 further comprising means for rotating the substrate.

3. Apparatus according to Claim 1 or Claim 2 in which:
the at least one electron beam evaporation source includes at least two electron beam evaporation sources;
the at least two regions comprises at least two adjacent regions;
a first of the at least two electron beam evaporation sources is located opposite to one of the two adjacent regions and a second of the at least two electron beam evaporation sources is located opposite to another of the at least two adjacent regions; and
wherein the apparatus further comprises:
sensing means for sensing failure of either the first or second electron beam evaporation sources; and
control means for automatically adjusting deposition time in case of failure of either of the first and second electron beam evaporation sources.

4. A combination comprising:
a substrate for a field emission source, the substrate having vias penetrating lift-off and insulator layers; and
an apparatus for forming Spindt emitters within the vias through electron beam evaporation and such that a maximum allowed deposition angle is not exceeded, the apparatus comprising:
at least one electron beam evaporation source located opposite to the substrate and generating at least one vapour cloud to deposit a substance forming the spindt emitters on at least two regions of the substrate located adjacent to one another; and
at least one partition configured to confine the at least vapour cloud to each of the at least two regions so that deposition on each one of the at least two regions does not exceed the maximum allowed deposition angle in other of the at least two regions;
the at least one electron beam evaporation source spaced from the substrate a source to substrate distance so that the maximum allowed deposition angle is not exceeded in each of the at least two regions of the substrate;
the source to substrate distance being less than that required to not exceed the maximum allowed deposition angle had a single electron beam evaporation source been used simultaneously to deposit the substance on the at least two regions of the substrate.

5. A method of depositing a Spindt emitter forming substance on a field emission source substrate by electron beam evaporation so that a maximum allowed deposition angle is not exceeded, the method comprising:
depositing the substance on at least two adjacent regions of the substrate by electron beam evaporation of the substance in at least one electron beam evaporation source;
spacing the at least one electron beam evaporation sources from the substrate a source to substrate distance so that the maximum allowed deposition angle is not exceeded in each of the at least two adjacent regions of the substrate;
the source to substrate distance being less than that required to not exceed the maximum allowed deposition angle had a single electron beam evaporation source been used simultaneously to deposit the substance on all of the at least two adjacent regions of the substrate; and
positioning at least one partition to confine at least one vapour cloud emanating from the at least one electron beam evaporation source to each of the at least two adjacent regions so that deposition on each one of the at least two regions does not exceed the maximum allowed deposition angle in other of the at least two regions.

6. A method according to Claim 5, further comprising rotating substrate.

7. A method according to Claim 6, further comprising:
monitoring deposition rate on at least each side of the at least one partition; and
adjusting deposition time in case of failure of one of the at least two electron beam evaporation sources.
